# FASCICULE DE BREVET EUROPEEN

(11) **EP 2 778 121 B1**
(45) Date de publication et mention de la délivrance du brevet: **26.06.2019**
(21) Numéro de dépôt: 14158272.6
(22) Date de dépôt: 07.03.2014
(51) Int. Cl.: B81C 1/00

(54) **Procédé d'encapsulation de micro-dispositif par scellement anodique**
Einkapselungsverfahren einer Mikrovorrichtung durch anodisches Bonden
Method for encapsulating microdevice by anodic bonding

(30) Priorité: 13.03.2013 FR 1352217
(43) Date de publication de la demande: 17.09.2014
(73) Titulaire: Commissariat à l'Énergie Atomique et aux Énergies Alternatives, 75015 Paris (FR)
(72) Inventeur: Nicolas, Stéphane, 38240 Meylan (FR)
(74) Mandataire: Ilgart, Jean-Christophe

(56) Documents cités:
- DE-A1-102004 043 120
- US-A1- 2007 006 434
- US-A1- 2008 099 908
- US-B2- 8 164 174

## Description

### DOMAINE TECHNIQUE ET ART ANTÉRIEUR

L'invention concerne le domaine de la microélectronique et plus particulièrement celui du packaging, ou encapsulation, de micro-dispositifs tels que ceux de type MEMS et/ou NEMS, permettant d'encapsuler hermétiquement ces micro-dispositifs dans des cavités dont l'atmosphère peut être contrôlée, via un scellement anodique.

L'encapsulation d'un micro-dispositif permet d'une part de le protéger des éléments extérieurs (humidité, pollution particulaire, éléments réactifs tels que l'oxygène ou autres gaz non neutres), et d'autre part de contrôler l'atmosphère de la cavité dans laquelle est encapsulé le micro-dispositif, à la fois en pression et en composition (la composition correspondant à la nature du ou des gaz destinés à être enfermés dans la cavité avec le micro-dispositif). Les pressions d'encapsulation sont très variables suivant l'application du micro-dispositif, et sont généralement comprises entre environ 1 bar à 10⁻³ mbar.

Une contrainte récurrente dans le domaine du packaging est donc de pouvoir réaliser un contrôle très précis de la pression et de la composition gazeuse dans les cavités. Par exemple, pour un micro-dispositif de type gyroscope, un vide poussé est généralement nécessaire à son bon fonctionnement. Selon les performances visées du gyroscope, la gamme de pressions souhaitée dans la cavité se situe entre environ 10⁻¹ mbar et 10⁻⁴ mbar pour les dispositifs les plus performants. Pour un micro-dispositif de type switch RF, ou commutateur RF, une pression proche de la pression atmosphérique est suffisante, mais un environnement gazeux « neutre » est par contre recherché pour éviter, par exemple, une oxydation de la zone de contact du switch. En conséquence, il est nécessaire d'utiliser des gaz non réactifs de type N₂, Ar, He, etc, pour une telle encapsulation.

L'encapsulation de micro-dispositifs est généralement réalisée à l'échelle du substrat via la mise en oeuvre d'un procédé d'encapsulation collectif de plusieurs micro-dispositifs simultanément, ce qui permet de réduire les coûts de packaging, et donc de fabrication, de ces micro-dispositifs. Une telle encapsulation peut être réalisée soit par un report de couches minces directement sur le substrat comprenant les micro-dispositifs (procédé également appelé PCM pour « Packaging Couche Mince »), soit par un scellement hermétique d'un second substrat, appelé substrat capot, sur le premier substrat comportant les micro-dispositifs. Les cavités peuvent dans ce cas être réalisées au préalable dans le substrat capot.

Dans le cas d'une encapsulation par scellement entre deux substrats, il existe différentes techniques permettant d'obtenir un assemblage hermétique du premier substrat avec le substrat capot : scellement moléculaire, scellement métallique, scellement par verre fritté, ou encore scellement anodique.

Le scellement anodique, qui permet d'obtenir une bonne herméticité, nécessite l'utilisation d'un substrat capot en verre par exemple de type borosilicate, contenant des ions sodium capables de se déplacer dans le verre sous l'effet d'un champ électrique appliqué lors du scellement. Toutefois, un tel substrat en verre de type borosilicate présente l'inconvénient d'être perméable aux gaz nobles tels que l'hélium ou l'argon. Cela signifie qu'une quantité non négligeable de gaz noble est susceptible de rentrer dans la cavité via le substrat capot après le scellement, et ainsi dégrader la pression résiduelle et la composition recherchées dans la cavité. Cela pose un problème majeur de fiabilité dans le cas d'un micro-dispositif qui requiert, pour être fonctionnel, un contrôle précis de la pression résiduelle et/ou de la nature de la composition gazeuse dans la cavité dans laquelle il est encapsulé. De plus, un fort dégazage d'oxygène se produit dans la cavité pendant le scellement anodique : en effet, lorsque l'on applique le champ électrique lors du scellement, les ions sodium vont migrer vers la surface externe du verre et, en contrepartie, les ions oxygène contenus dans le verre vont migrer vers la surface interne du substrat et ainsi rentrer dans la cavité, venant ainsi modifier l'atmosphère recherchée dans la cavité.

Le scellement anodique peut également être réalisé via l'utilisation d'une couche intermédiaire en verre par exemple de type borosilicate déposée par une technique de dépôt sous vide (de type PVD, ou dépôt physique en phase vapeur) sur le substrat capot. Le dépôt d'une telle couche de verre intermédiaire est par exemple décrit dans le document "The silicon-to-silicon anodic bonding using sputter deposited intermediate glass layer", R. Tiwari et al., J. Nano- Electron. Phys. ; 3 (2011) No1, P. 418-425. Les documents US 5 591679 et US 2007/0006434 A1 décrivent également la réalisation d'une telle couche intermédiaire en verre. Le document US 2007/087465 A1 décrit la réalisation d'un substrat capot formé par l'assemblage d'un substrat de silicium avec une fine couche de verre, puis assemblé par scellement anodique avec un deuxième substrat comportant un micro-dispositif. Le substrat capot possède plusieurs cavités qui ont été gravées partiellement dans le verre. Le document US 2007/006434 A1 décrit un procédé d'encapsulation d'au moins un micro-dispositif, comportant la mise en oeuvre des étapes de : dépôt d'une couche de verre sur une face d'un premier substrat; gravure d'une cavité à travers la couche de verre telle que des parois latérales de la cavité soient formées au moins en partie par des portions restantes de la couche de verre et qu'une paroi supérieure de la cavité soit formée par une partie de ladite face du premier substrat; scellement anodique des portions restantes de la couche de verre contre un troisième substrat comprenant le micro-dispositif, tel que le micro-dispositif soit encapsulé dans la cavité.

Bien que l'utilisation d'une telle fine couche de verre formée contre un substrat capot à base d'un autre matériau non perméable vis-à-vis des gaz nobles réduit les problèmes de perméabilité aux gaz nobles rencontrés avec un substrat capot entièrement composé de verre, ces couches de verre posent des problèmes de fragilité et de risques de casse lors de leur réalisation et de leur manipulation avant le scellement avec le substrat comportant les micro-dispositifs. De plus, la réalisation d'une telle fine couche de verre implique la mise en oeuvre d'un dépôt PVD qui est un procédé long et coûteux. Enfin, une telle couche de verre n'apporte pas de solution au problème du dégazage d'oxygène se produisant dans la cavité lors du scellement anodique.

Aucun des procédés de l'art antérieur ne permet donc de réaliser un scellement anodique tout en garantissant un contrôle précis de l'atmosphère (en termes de pression et/ou de composition) de la cavité dans laquelle le micro-dispositif est encapsulé.

### EXPOSÉ DE L'INVENTION

Un but de la présente invention est de proposer un procédé d'encapsulation de micro-dispositif par scellement anodique permettant de réaliser un contrôle précis de l'atmosphère (en termes de pression et/ou de composition) de la cavité dans laquelle le micro-dispositif est encapsulé, évitant la mise en oeuvre d'un dépôt PVD et réduisant les risques de casse et de fragilité liés à l'utilisation d'une couche mince de verre.

Pour cela, la présente invention propose un procédé d'encapsulation d'au moins un micro-dispositif, comportant au moins la mise en oeuvre des étapes de :
- solidarisation d'une face d'un premier substrat comprenant au moins un matériau non perméable vis-à-vis de gaz nobles, contre un deuxième substrat comprenant du verre et d'épaisseur supérieure ou égale à 300 µm ;
- gravure d'au moins une cavité à travers le deuxième substrat telle que des parois latérales de la cavité soient formées au moins en partie par des portions restantes du deuxième substrat et qu'une paroi supérieure de la cavité soit formée par au moins une partie de ladite face du premier substrat ;
- scellement anodique des portions restantes du deuxième substrat contre un troisième substrat comprenant le micro-dispositif, tel que le micro-dispositif soit encapsulé dans la cavité.

La paroi supérieure de la cavité peut être formée par une partie de ladite face du premier substrat.

Les portions restantes du deuxième substrat forment un joint de scellement hermétique entre le premier substrat et le troisième substrat.

Du fait que le premier substrat comporte au moins un matériau non perméable vis-à-vis des gaz noble, ces gaz ne peuvent donc pas pénétrer dans la cavité via le substrat capot une fois l'encapsulation du micro-dispositif achevée. De plus, le fait que la paroi supérieure de la cavité soit formée par une partie du premier substrat et non par du verre, cela réduit fortement la quantité d'oxygène qui peut diffuser dans la cavité au cours du scellement anodique.

De plus, le fait que le substrat capot soit formé par le premier substrat auquel est solidarisé le deuxième substrat de verre permet d'éviter la mise en oeuvre d'un dépôt PVD, et permet donc de réduire les coûts d'encapsulation du micro-dispositif.

Enfin, l'utilisation du deuxième substrat de verre d'épaisseur supérieure ou égale à 300 µm résout les problèmes de fragilité rencontrés avec les couches minces de verre utilisées dans les procédés de l'art antérieur. Par exemple, lorsque le deuxième substrat de verre correspond à une couche cylindrique (wafer) de diamètre égal à environ 150 mm, son épaisseur peut être supérieure ou égale à 300 µm. Lorsque le deuxième substrat de verre correspond à une couche cylindrique de diamètre égal à environ 200 mm, son épaisseur peut être supérieure ou égale à environ 500 µm.

Lorsque le deuxième substrat de verre correspond à une couche cylindrique de diamètre égal à environ 300 mm, son épaisseur peut être supérieure ou égale à environ 775 µm.

Le deuxième substrat de verre forme un substrat autonome, c'est-à-dire un substrat présentant un maintien mécanique suffisant pour être autoporté et donc être manipulé sans risque de le casser, notamment préalablement et au cours de la solidarisation avec le premier substrat.

La structure d'encapsulation obtenue comporte un support (correspondant au troisième substrat) assemblé hermétiquement par scellement anodique à un capot comportant une cavité contenant au moins un micro-dispositif par exemple de type MEMS et/ou NEMS. Le capot est formé par un substrat hermétique (premier substrat) sur lequel est disposée une couche épaisse de verre structurée pour former la cavité, le scellement anodique étant réalisé entre ladite couche de verre et le support en périphérie de la cavité.

Le troisième substrat peut comporter au moins un matériau non perméable vis-à-vis des gaz noble, par exemple du silicium.

Le matériau non perméable vis-à-vis de gaz nobles peut être du silicium, et/ou le verre du deuxième substrat peut être de type borosilicate.

Le procédé peut comporter en outre, préalablement au scellement anodique, une étape de réalisation d'un matériau getter sur la partie de ladite face du premier substrat et/ou sur au moins une partie des parois latérales de la cavité et/ou sur au moins une partie du troisième substrat destinée à être disposée dans la cavité. L'ajout d'un matériau getter dans la cavité permet d'assurer la qualité de l'atmosphère régnant dans la cavité en piégeant d'éventuels gaz résiduels tels que de l'oxygène, de l'azote, de l'hydrogène, de l'eau, du monoxyde de carbone ou encore du dioxyde de carbone, et éventuellement d'obtenir un vide poussé dans la cavité (par exemple de pression inférieure à environ 10⁻¹ mbar).

Le procédé peut comporter en outre, entre l'étape de solidarisation du premier substrat contre le deuxième substrat et l'étape de gravure de la cavité, un amincissement du deuxième substrat à une épaisseur de préférence supérieure ou égale à environ 10 µm, et par exemple comprise entre l'épaisseur initial du deuxième substrat et environ 10 µm.

Le procédé peut comporter en outre, entre l'étape de gravure de la cavité et l'étape de scellement anodique, une réalisation d'au moins une portion de matériau non perméable vis-à-vis de gaz nobles au moins contre les parois latérales de la cavité. On obtient ainsi une cavité totalement hermétique vis-à-vis des gaz nobles.

La portion de matériau non perméable vis-à-vis de gaz nobles peut comporter au moins un métal (par exemple du titane et/ou de l'aluminium et/ou du cuivre) et/ou du silicium.

La portion de matériau non perméable vis-à-vis de gaz nobles peut recouvrir également la paroi supérieure de la cavité.

La portion de matériau non perméable vis-à-vis de gaz nobles peut former une couche déposée en outre contre les portions restantes du deuxième substrat, le scellement anodique des portions restantes du deuxième substrat contre le troisième substrat pouvant être mis en oeuvre entre la portion de matériau non perméable vis-à-vis de gaz nobles et le troisième substrat.

La mise en oeuvre dudit procédé peut réaliser une encapsulation collective de plusieurs micro-dispositifs dans des cavités distinctes, et peut comporter en outre, après le scellement anodique des portions restantes du deuxième substrat contre le troisième substrat, une découpe au moins du premier substrat et du troisième substrat telle que chacun des micro-dispositifs encapsulé forme une puce.

Dans le cas d'un procédé d'encapsulation collectif, le deuxième substrat peut être prédécoupé entre les différentes puces destinées à être réalisées, avant le scellement avec le troisième substrat. Cette prédécoupe peut être obtenue par une gravure du deuxième substrat sur toute son épaisseur mise en oeuvre en même temps que la réalisation des cavités dans le deuxième substrat. Ainsi, la prédécoupe du verre ne nécessite pas la mise en oeuvre d'étape supplémentaire, mais seulement l'utilisation d'un masque de gravure adapté à la réalisation d'une gravure simultanée des cavités et des tranchées séparant les cavités des différentes puces. Dans le cas d'une prédécoupe du deuxième substrat, l'individualisation des puces après scellement ne nécessite que la découpe que du premier et du troisième substrats. Dans le cas contraire, les premier, deuxième et troisième substrats sont découpés après le scellement avec le troisième substrat.

Dans ce cas, le procédé peut comporter en outre, après l'étape de découpe, une étape de dépôt d'au moins une couche de matériau non perméable vis-à-vis de gaz nobles contre au moins des flancs latéraux extérieurs des portions restantes du deuxième substrat. Ce dépôt permet ainsi de rendre la cavité totalement hermétique vis-à-vis des gaz nobles.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1E représentent schématiquement les étapes d'un procédé d'encapsulation d'un micro-dispositif, objet de la présente invention, selon un premier mode de réalisation ;
- les figures 2A à 2D représentent schématiquement une partie des étapes d'un procédé d'encapsulation d'un micro-dispositif, objet de la présente invention, selon un deuxième mode de réalisation ;
- les figures 3 à 5 représentent schématiquement des structures d'encapsulation obtenues via la mise en oeuvre d'un procédé d'encapsulation d'un micro-dispositif, objet de la présente invention, selon différentes variantes de réalisation ;

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

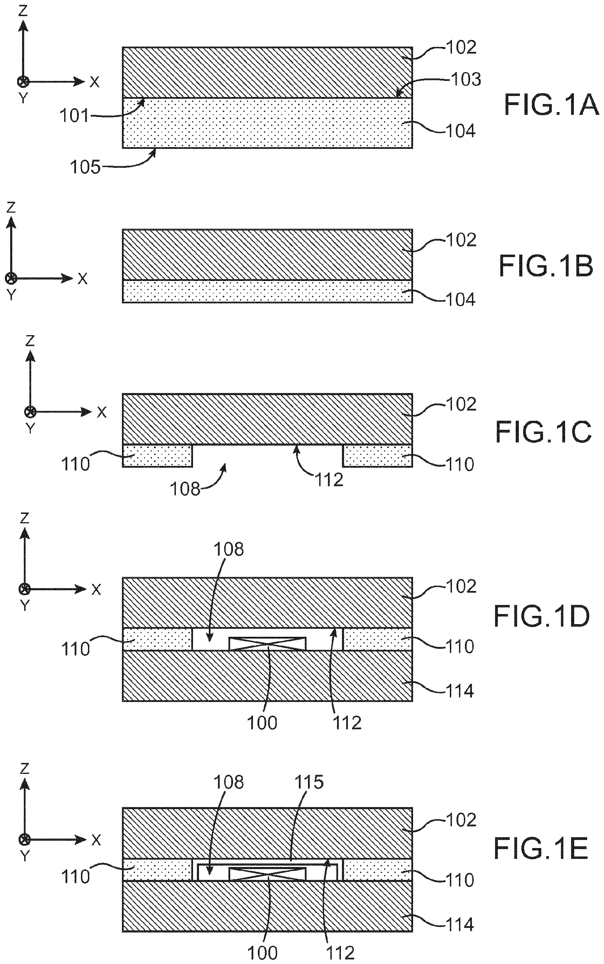

On se réfère tout d'abord aux figure 1A à 1D qui représentent schématiquement les étapes d'un procédé d'encapsulation d'un micro-dispositif 100, par exemple de type MEMS et/ou NEMS, selon un premier mode de réalisation.

Comme représenté sur la figure 1A, le capot de la structure d'encapsulation est tout d'abord préparé à partir d'un premier substrat 102 comprenant au moins un matériau non perméable aux gaz nobles (hélium, argon, etc.) tel que du semi-conducteur, par exemple du silicium. Le premier substrat 102 est solidarisé à un deuxième substrat 104 massif comprenant du verre et dont l'épaisseur (dimension selon l'axe Z représenté sur la figure 1A) est par exemple supérieure ou égale à environ 500 µm.

Le premier substrat 102 et le deuxième substrat 104 correspondent ici à des wafers de forme cylindrique et de diamètre (dimension appartenant au plan (X,Y)) égal à environ 200 mm. La solidarisation entre le premier substrat 102 et le deuxième substrat 104 est réalisée ici par un scellement anodique entre les deux substrats, au niveau d'une première face 101 du premier substrat 102 et d'une première face 103 du deuxième substrat 104. La nature du verre du deuxième substrat 104, par exemple du verre borosilicate tel que du verre borosilicate flotté de type borofloat®, est choisie dans ce cas telle qu'elle soit compatible pour la réalisation d'un scellement anodique avec le premier substrat 102. En variante, le deuxième substrat 104 peut être solidarisé au premier substrat 102 par un collage direct, ou collage moléculaire.

Le deuxième substrat 104 est ensuite aminci au niveau d'une face 105 opposée à la face 103 tel qu'une couche de verre restante correspondant au deuxième substrat 104 aminci ait une épaisseur comprise entre environ 10 µm et l'épaisseur initiale du deuxième substrat 104, ici égale à 500 µm (figure 1B). Cet amincissement est par exemple réalisé via la mise en oeuvre d'un polissage mécanique (meulage ou « grinding » en anglais, puis planarisation mécano-chimique (CMP)) au niveau de la face 105 du deuxième substrat 104, ou par la mise en oeuvre d'une gravure chimique suivie d'une CMP au niveau de la face 105.

En variante, il est possible de ne pas mettre en oeuvre cette étape d'amincissement du deuxième substrat 104 et de conserver la totalité de l'épaisseur du deuxième substrat 104 pour les étapes suivantes.

Le deuxième substrat 104, aminci ou non, est ensuite structuré en gravant dans celui-ci une cavité 108 dans laquelle le micro-dispositif 100 est destiné à être encapsulé. La cavité 108 est formée dans toute l'épaisseur restante du deuxième substrat 104 via une gravure humide. La hauteur (dimension selon l'axe Z) de la cavité 108 correspond donc ici à l'épaisseur de la couche de verre restante correspondant au deuxième substrat 104 aminci ou non. Des portions restantes 110 du deuxième substrat 104 forment des parois périphériques, ou parois latérales, de la cavité 108, tandis qu'une partie 112 de la face 101 du premier substrat 102 initialement solidarisée au deuxième substrat 104 forme la paroi supérieure de la cavité 108 (figure 1C).

Le procédé d'encapsulation est achevé en réalisant un scellement anodique entre les portions restantes 110 du deuxième substrat 104 et un troisième substrat 114, ici à base de semi-conducteur tel que du silicium, sur lequel est réalisé au préalable le micro-dispositif 100, tel que le micro-dispositif 100 soit encapsulé dans la cavité 108 qui est délimitée par le premier substrat 102, les portions restantes 110 du deuxième substrat 104 et le troisième substrat 114 (figure 1D). Le scellement anodique peut être mis en oeuvre dans une atmosphère gazeuse correspondant à celle souhaitée dans la cavité 108, par exemple à une pression comprise entre la pression atmosphérique et un vide poussé (par exemple entre environ 10⁻² mbar et 10⁻⁴ mbar) et/ou en présence de gaz particuliers permettant d'avoir un bon fonctionnement du micro-dispositif 100 comme par exemple de l'azote.

Le procédé d'encapsulation précédemment décrit fait appel à un verre de type borosilicate ou borofloat® parfaitement adapté à la mise en oeuvre d'un scellement anodique avec le substrat semi-conducteur sur lequel est réalisé le micro-dispositif à encapsuler. Ce procédé permet en outre d'éviter des problèmes de fragilité et de risques de casses liés à des manipulations d'une couche mince de verre lors de l'encapsulation car la couche de verre servant à la réalisation des parois latérales de la cavité est obtenue à partir d'un substrat de verre 104 épais et solidarisé au premier substrat 102 avant un éventuel amincissement, ce premier substrat 102 servant de poignée mécanique lors de manipulations de la couche de verre une fois celle-ci réalisée.

L'épaisseur initiale du substrat de verre 104 (au moins de 300 µm) permet en outre de le manipuler préalablement à sa solidarisation au premier substrat 102 sans que cela pose de problèmes de fragilité et de risques de casses qu'avec une couche mince de verre.

La cavité 108 est définie, ou formée, dans la totalité de l'épaisseur de la couche de verre correspondant au deuxième substrat 104 aminci ou non. La hauteur de la cavité 108 peut donc varier de quelques microns, par exemple 10 µm, à l'épaisseur initiale du substrat de verre 104, par exemple égale à 500 µm ou égale à environ 1 mm.

De plus, la surface interne en verre de la cavité 108 est limitée aux flancs latéraux formés par les portions 110 du deuxième substrat 104. Ainsi, la quantité d'oxygène dégazé par le verre et entrant dans la cavité 108 lors du scellement anodique est fortement limitée par rapport à une structure d'encapsulation comportant un capot de verre ou une couche de verre recouvrant les parois latérales et la paroi supérieure du capot, ou plus généralement une structure d'encapsulation dans laquelle les parois latérales et la paroi supérieure de la cavité sont en verre.

Dans une variante de réalisation, il est possible de réaliser, préalablement au scellement avec le troisième substrat 114, le dépôt d'un matériau getter 115 sur le premier substrat 102 (au moins au niveau d'une partie de la paroi supérieure de la cavité 108) et/ou sur au moins une partie des parois latérales de la cavité 108 formées par les portions 110 du deuxième substrat 104 et/ou sur le troisième substrat 114 (au moins au niveau d'une partie de la paroi inférieure de la cavité 108). Une telle variante de réalisation est représentée sur la figure 1E, sur laquelle une couche de matériau getter 115 est formée contre la partie 112 de la face 101 du premier substrat 102 et contre les parois latérales de la cavité 108 formées par les portions 110 du deuxième substrat 104.

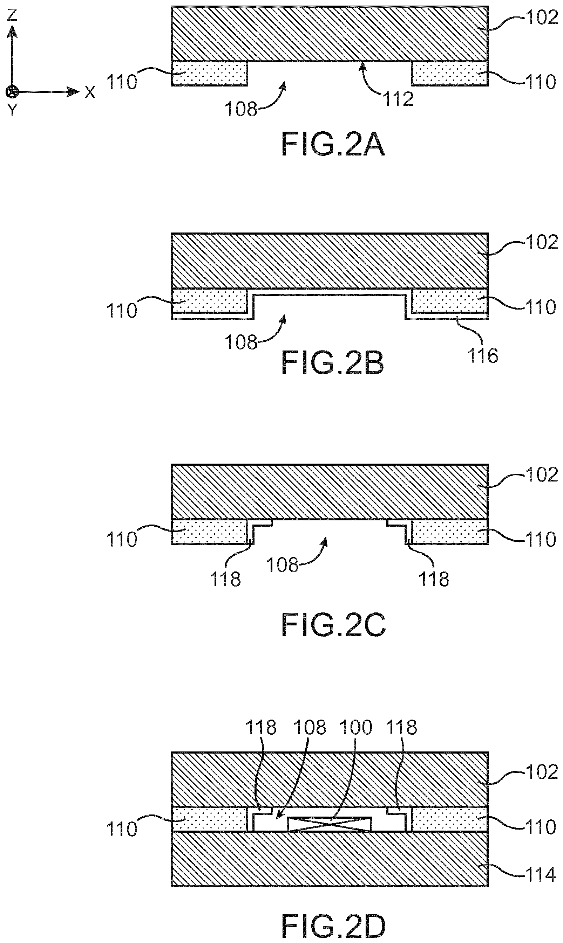

On se réfère maintenant aux figures 2A à 2D qui représentent une partie des étapes d'un procédé d'encapsulation du micro-dispositif 100 selon un deuxième mode de réalisation.

Les étapes précédemment décrites en liaison avec les figures 1A à 1C sont tout d'abord mises en oeuvre, formant ainsi la cavité 108 délimitée par les portions restantes 110 de verre solidarisées contre le premier substrat 102 (figure 2A).

Comme représenté sur la figure 2B, une couche 116 de matériau apte à former une barrière vis-à-vis des gaz nobles, c'est-à-dire non perméable au gaz nobles, est déposée sur les parois de la cavité 108, c'est-à-dire sur les portions 110 ainsi que sur la partie 112 de la face du premier substrat 102 formant la paroi supérieure de la cavité 108.

Cette couche 116 est par exemple à base d'au moins un matériau métallique tel que du titane, de l'aluminium ou du cuivre, déposé par PVD. L'épaisseur de la couche 116 est par exemple comprise entre environ 0,5 µm et 2 µm.

La couche 116 est ensuite gravée afin de ne conserver que des portions restantes 118 de la couche 116 recouvrant les parois latérales de la cavité 108 formées par les portions 110 de verre (figure 2C). La paroi supérieure de la cavité 108 est également recouverte en partie par ces portions restantes 118. Toutefois, il est possible que les portions restantes 118 de la couche 116 ne recouvrent que les parois latérales de la cavité 108.

Le procédé d'encapsulation est ensuite achevé via la solidarisation par scellement anodique des portions de verre 110 avec le troisième substrat 114, encapsulant le micro-dispositif 100 dans la cavité 108 (figure 2D).

Ainsi, dans ce deuxième mode de réalisation, les parois latérales de la cavité 108 ne sont pas perméables aux gaz nobles grâce à la présence des portions 118 de matériau métallique formant un écran vis-à-vis de ces gaz nobles susceptibles de traverser les portions de verre 110.

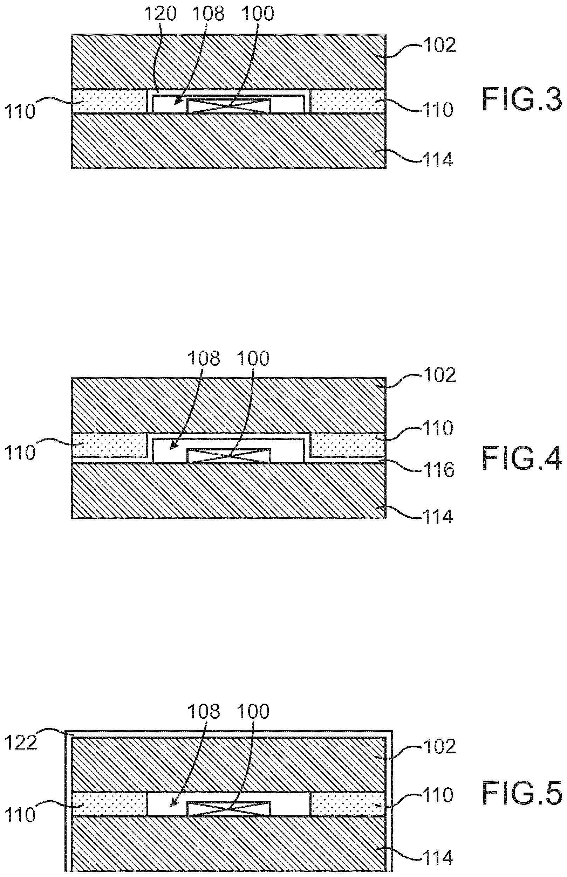

Dans une première variante de réalisation représentée sur la figure 3, il est possible que la couche métallique 116 soit structurée telle qu'une portion restante 120 de cette couche recouvre à la fois les parois latérales de la cavité 108, c'est-à-dire les parois latérales formées par les portions 110, ainsi que la totalité de la paroi supérieure de la cavité 108, c'est-à-dire toute la partie 112 de la face du premier substrat 102.

Dans une deuxième variante de réalisation représentée sur la figure 4, il est possible que la couche métallique 116 ne soit pas structurée. Dans ce cas, le scellement anodique est réalisé entre le troisième substrat 114 et la couche métallique 116, la couche métallique 116 étant alors réalisée de préférence à partir d'un matériau métallique facilement oxydable comme par exemple du titane ou de l'aluminium.

Une autre solution permettant d'éviter une possible perméation de gaz nobles dans la cavité 108 à travers les portions de verre 110 peut consister à réaliser la structure d'encapsulation précédemment décrite en liaison avec les figures 1A - 1D, puis de protéger les flancs extérieurs des portions de verre 110 par le dépôt conforme d'une couche métallique 122 au moins contre ces flancs extérieurs. Sur l'exemple de la figure 5, la couche métallique 122 recouvre en outre les flancs latéraux du troisième substrat 114 et du premier substrat 102, ainsi que la face supérieure du premier substrat 102.

Dans les exemples de réalisation décrits en liaison avec les figures 2A-2D, 3, 4 et 5, il est également possible de réaliser le dépôt d'un matériau getter dans la cavité 108. Le matériau getter peut alors être déposé directement sur une ou plusieurs des parois de la cavité 108 formées par les substrats 102, 114 et/ou les portions de verre 110, et/ou sur au moins une partie du matériau apte à former une barrière vis-à-vis des gaz nobles se trouvant dans la cavité 108. Ainsi, lorsque le procédé comporte une étape de réalisation d'au moins une portion de matériau non perméable vis-à-vis de gaz nobles au moins contre les parois latérales de la cavité et/ou la paroi supérieure de la cavité, le matériau getter peut être réalisé après cette étape.

Dans les procédés d'encapsulation précédemment décrits, l'encapsulation d'un seul micro-dispositif 100 est décrite. Toutefois, ces procédés sont avantageusement mis en oeuvre de manière collective afin de réaliser simultanément l'encapsulation de plusieurs micro-dispositifs, par exemple similaires au micro-dispositif 100, dans des cavités distinctes toutes formées à partir des substrats 102, 104 et 114 et par exemple similaires à la cavité 108. Dans ce cas, après la mise en oeuvre du scellement anodique, les éléments (premier substrat 102, portions de verre 110, troisième substrat 114, et éventuellement couche métallique 116) formant les structures d'encapsulation sont découpés afin que chaque micro-dispositif 100 encapsulé individuellement forme une puce indépendante des autres puces formées par les autres micro-dispositifs encapsulés. Dans le cas précédemment décrit en liaison avec la figure 5, le dépôt de la couche métallique 122 est mis en oeuvre après ces étapes de découpe et de séparation des puces. Ce dépôt de la couche métallique 122 peut être mis en oeuvre pour plusieurs puces simultanément.

## Revendications

1. Procédé d'encapsulation d'au moins un micro-dispositif (100), comportant au moins la mise en oeuvre des étapes de :
- solidarisation d'une face (101) d'un premier substrat (102) comprenant au moins un matériau non perméable vis-à-vis de gaz nobles, contre un deuxième substrat (104) comprenant du verre et d'épaisseur supérieure ou égale à 300 µm ;
- gravure d'au moins une cavité (108) à travers le deuxième substrat (104) telle que des parois latérales de la cavité (108) soient formées au moins en partie par des portions restantes (110) du deuxième substrat (104) et qu'une paroi supérieure de la cavité (108) soit formée par une partie (112) de ladite face (101) du premier substrat (102) ;
- scellement anodique des portions restantes (110) du deuxième substrat (104) contre un troisième substrat (114) comprenant le micro-dispositif (100), tel que le micro-dispositif (100) soit encapsulé dans la cavité (108).

2. Procédé selon la revendication 1, dans lequel le matériau non perméable vis-à-vis de gaz nobles est du silicium, et/ou le verre du deuxième substrat (104) est de type borosilicate.

3. Procédé selon l'une des revendications précédentes, comportant en outre, préalablement au scellement anodique, une étape de réalisation d'un matériau getter (115) sur la partie (112) de ladite face (101) du premier substrat (102) et/ou sur au moins une partie des parois latérales de la cavité (108) et/ou sur au moins une partie du troisième substrat (114) destinée à être disposée dans la cavité (108).

4. Procédé selon l'une des revendications précédentes, comportant en outre, entre l'étape de solidarisation du premier substrat (102) contre le deuxième substrat (104) et l'étape de gravure de la cavité (108), un amincissement du deuxième substrat (104) à une épaisseur supérieure ou égale à environ 10 µm.

5. Procédé selon l'une des revendications précédentes, comportant en outre, entre l'étape de gravure de la cavité (108) et l'étape de scellement anodique, une réalisation d'au moins une portion (116, 118, 120) de matériau non perméable vis-à-vis de gaz nobles au moins contre les parois latérales de la cavité (108).

6. Procédé selon la revendication 5, dans lequel la portion (116, 118, 120) de matériau non perméable vis-à-vis de gaz nobles comporte au moins un métal et/ou du silicium.

7. Procédé selon l'une des revendications 5 ou 6, dans lequel la portion (116, 120) de matériau non perméable vis-à-vis de gaz nobles recouvre également la paroi supérieure de la cavité (108).

8. Procédé selon l'une des revendications 5 à 7, dans lequel la portion (116) de matériau non perméable vis-à-vis de gaz nobles forme une couche déposée en outre contre les portions restantes (110) du deuxième substrat (104), le scellement anodique des portions restantes (110) du deuxième substrat (104) contre le troisième substrat (114) étant mis en oeuvre entre la portion (116) de matériau non perméable vis-à-vis de gaz nobles et le troisième substrat (114).

9. Procédé selon l'une des revendications précédentes, dans lequel la mise en oeuvre dudit procédé réalise une encapsulation collective de plusieurs micro-dispositifs (100) dans des cavités (108) distinctes, et comporte en outre, après le scellement anodique des portions restantes (110) du deuxième substrat (104) contre le troisième substrat (114), une découpe au moins du premier substrat (102) et du troisième substrat (114) telle que chacun des micro-dispositifs (100) encapsulé forme une puce.

10. Procédé selon la revendication 9, comportant en outre, après l'étape de découpe, une étape de dépôt d'au moins une couche (122) de matériau non perméable vis-à-vis de gaz nobles contre au moins des flancs latéraux extérieurs des portions restantes (110) du deuxième substrat (104).

## Patentansprüche

1. Verfahren zur Verkapselung wenigstens einer Mikrovorrichtung (100), welches wenigstens die Ausführung der folgenden Schritte umfasst:
- Verbindung einer Seite (101) eines ersten Substrats (102), umfassend wenigstens ein für Edelgase undurchlässiges Material, gegenüber einem Glas umfassenden zweiten Substrat (104) mit einer Dicke größer gleich 300 µm;
- Bilden wenigstens eines Hohlraums (108) in dem zweiten Substrat (104) derart, dass die Seitenwände des Hohlraums (108) wenigstens teilweise durch verbleibende Abschnitte (110) des zweiten Substrats (104) gebildet werden und dass eine obere Wand des Hohlraums (108) durch einen Teil (112) der Seite (101) des ersten Substrats (102) gebildet wird;
- Anodenabdichtung der verbleibenden Abschnitte (110) des zweiten Substrats (104) gegenüber einem die Mikrovorrichtung (100) umfassenden dritten Substrat (114), derart, dass die Mikrovorrichtung (100) in dem Hohlraum (108) eingekapselt wird.

2. Verfahren nach Anspruch 1, bei welchem das für Edelgase undurchlässige Material Silizium ist, und/oder wobei das Glas des zweiten Substrats (104) vom Typ Borosilikat ist.

3. Verfahren nach einem der vorhergehenden Ansprüche, welches ferner vor der Anodenabdichtung einen Schritt der Ausführung eines Gettermaterials (115) auf dem Teil (112) der Seite (101) des ersten Substrats (102) umfasst und/oder auf wenigstens einem Teil der Seitenwände des Hohlraums (108) und/oder auf wenigstens einem Teil des dritten Substrats (114), der in dem Hohlraum (108) angeordnet werden soll.

4. Verfahren nach einem der vorhergehenden Ansprüche, welches ferner zwischen dem Schritt der Verbindung des ersten Substrats (102) gegenüber dem zweiten Substrat (104) und dem Schritt des Bildens des Hohlraums (108) ein Verdünnen des zweiten Substrats (104) auf eine Dicke größer gleich ungefähr 10 µm umfasst.

5. Verfahren nach einem der vorhergehenden Ansprüche, welches ferner zwischen dem Schritt des Bildens des Hohlraums (108) und dem Schritt der Anodenabdichtung die Ausführung wenigstens eines für Edelgase undurchlässigen Materialteils (116, 118, 120) wenigstens an den Seitenwänden des Hohlraums (108) umfasst.

6. Verfahren nach Anspruch 5, bei welchem das für Edelgase undurchlässige Materialteil (116,118, 120) wenigstens ein Metall und/oder Silizium umfasst.

7. Verfahren nach Anspruch 5 oder 6, bei welchem das für Edelgase undurchlässige Materialteil (116, 120) auch die obere Wand des Hohlraums (108) bedeckt.

8. Verfahren nach einem der Ansprüche 5 bis 7, bei welchem das für Edelgase undurchlässige Materialteil (116) eine Schicht bildet, welche ferner an den verbleibenden Abschnitten (110) des zweiten Substrats (104) angebracht wird, wobei die Anodenabdichtung der verbleibenden Abschnitte (110) des zweiten Substrats (104) gegenüber dem dritten Substrat (114) zwischen dem für Edelgase undurchlässigen Materialteil (116) und dem dritten Substrat (114) ausgeführt wird.

9. Verfahren nach einem der vorhergehenden Ansprüche, bei welchem bei der Ausführung des Verfahrens eine gemeinsame Verkapselung mehrerer Mikrovorrichtungen (100) in unterschiedlichen Hohlräumen (108) durchgeführt wird und welches ferner nach der Anodenabdichtung der verbleibenden Abschnitte (110) des zweiten Substrats (104) gegenüber dem dritten Substrat (114) ein Ausschneiden wenigstens des ersten Substrats (102) und des dritten Substrats (114) derart umfasst, dass jede der verkapselten Mikrovorrichtungen (100) einen Chip bildet.

10. Verfahren nach Anspruch 9, welches ferner nach dem Schritt des Ausschneidens einen Schritt des Anbringens wenigstens einer Schicht (122) des für Edelgase undurchlässigen Materials an wenigstens den äußeren Seitenflächen der verbleibenden Abschnitte (110) des zweiten Substrats (104) umfasst.

## Claims

1. A method for encapsulating at least one micro-device (100), comprising at least the following steps:
- bonding a face (101) of a first substrate (102) comprising at least one material impermeable to noble gases, in contact with a second substrate (104) comprising glass and with a thickness of 300 µm or more;
- etching at least one cavity (108) through the second substrate (104) such that side walls of the cavity (108) are at least partly formed by remaining portions (110) of the second substrate (104) and that an upper wall of the cavity (108) is formed by part (112) of said face (101) of the first substrate (102);
- anodic bonding of the remaining portions (110) of the second substrate (104) in contact with a third substrate (114) in which the micro-device (100) is formed, such that the micro-device (100) is encapsulated in the cavity (108).

2. The method according to claim 1, in which the material impermeable to noble gases is silicon, and/or the glass in the second substrate (104) is of the borosilicate type.

3. The method according to one of previous claims, also comprising a step prior to anodic bonding, to produce a getter material (115) on the part (112) of said face (101) of the first substrate (102) and/or on at least part of the side walls of the cavity (108) and/or on at least part of the third substrate (114) intended to be arranged in the cavity (108).

4. The method according to one of previous claims, also comprising thinning of the second substrate (104), between the step for bonding the first substrate (102) in contact with the second substrate (104) and the step for etching the cavity (108), to a thickness greater than or equal to about 10 µm.

5. The method according to one of previous claims, also comprising a step to make at least a portion (116, 118, 120) of material impermeable to noble gases at least in contact with the side walls of the cavity (108), between the step for etching the cavity (108) and the anodic bonding step.

6. The method according to claim 5, in which the portion (116, 118, 120) of material impermeable to noble gases comprises at least a metal and/or silicon.

7. The method according to one of claims 5 or 6, in which the portion (116, 120) of material impermeable to noble gases also covers the upper wall of the cavity (108).

8. The method according to one of claims 5 to 7, in which the portion (116) of material impermeable to noble gases forms a layer also in contact with the remaining portions (110) of the second substrate (104), anodic bonding of the remaining portions (110) of the second substrate (104) in contact with the third substrate (114) being carried out between the portion (116) of material impermeable to noble gases and the third substrate (114).

9. The method according to one of previous claims, in which said method performs collective encapsulation of several micro-devices (100) in distinct cavities (108), and also comprises a cut-out in at least the first substrate (102) and the third substrate (114) after anodic bonding of the remaining portions (110) of the second substrate (104) in contact with the third substrate (114), such that each of the encapsulated micro-devices (100) forms a chip.

10. The method according to claim 9, also comprising, after the cutting step, a step for depositing at least one layer (122) of material impermeable to noble gases in contact with at least external side walls of the remaining portions (110) of the second substrate (104).
